# FASCICULE DE BREVET EUROPEEN

(11) **EP 1 504 636 B1**
(45) Date de publication et mention de la délivrance du brevet: **24.10.2007**
(21) Numéro de dépôt: 03740657.6
(22) Date de dépôt: 23.04.2003
(51) Int. Cl.: H05K 5/00, H05K 7/20, B60R 16/02, H05K 1/02

(54) **DISPOSITIF DE COMMUTATION DE PUISSANCE REFROIDI**
GEKÜHLTER LEISTUNGSSCHALTER
COOLED POWER SWITCHING DEVICE

(30) Priorité: 03.05.2002 FR 0205555
(43) Date de publication de la demande: 09.02.2005
(73) Titulaire: DAV, 78180 Montigny le Bretonneux (FR)
(72) Inventeur: LAURENT, Patrice, F-74250 Viuz en Sallaz (FR); MEYNET, Marc, F-74930 Reignier (FR); DEVILLER, Cécile, F-74800 La Roche sur Foron (FR); HERVIEU, Marc, 74800 Eteaux (FR)
(74) Mandataire: Bertrand, Didier
(86) Numéro de dépôt international: PCT/FR2003/001289
(87) Numéro de publication internationale: WO 2003/094585

(56) Documents cités:
- EP-A- 1 178 594
- DE-A- 19 518 522
- FR-A- 2 800 567

## Description

La présente invention concerne un dispositif de commutation de puissance, notamment destiné à des boîtiers d'interconnexion pour véhicules à moteurs à combustion ou bien électriques, utilisant des organes semi-conducteurs de commutation dont il faut évacuer au mieux la puissance thermique dissipée.

Le document FR 2 800 567 fait connaître un dispositif de commutation de puissance comportant des organes semi-conducteurs de commutation présentant deux jeux de connexions, lesdits dispositifs semi-conducteurs étant fixés par leur base sur une plaque de refroidissement de cuivre ou autre métal conducteur à laquelle est raccordé le premier jeu de connexions, tandis que le second jeu de connexion des dispositifs semi-conducteurs est relié à un circuit de commande et à des connecteurs de puissance. Les organes de commutation sont par exemple de type MOSFET ou SMART POWER ; dans le cas d'un MOSFET, le premier jeu de connexion comporte le drain et le second jeu de connexions comporte la grille et la source ; dans le cas d'un SMART POWER, le premier jeu de connexions comporte l'alimentation et le second jeu de connexions comporte les entrées 1 à n , les sorties 1 à n, le capteur de courant et la masse. Les organes de commutation comportent avantageusement une semelle (le drain pour un MOSFET) qui est directement accolée à la plaque de refroidissement, par brasure ou plaquage. Celle-ci est elle-même accolée à une plaque de support en plastique constituant une partie d'un boîtier et contribuant à la dissipation thermique vers l'extérieur par rayonnement. Les connexions du second jeu de connexions des organes de commutation sont reliées par des broches transversales à un circuit de routage disposé parallèlement à la plaque de refroidissement ; ces broches sont formées par des pattes découpées et pliées à partir de la plaque de cuivre servant au refroidissement et à la mise à l'équipotentialité des premières connexions. Le fait que la distribution électrique et le refroidissement thermique soient réalisés par une seule et même plaque de cuivre entraîne des limitations dans les possibilités d'organiser les circuits et de les rendre compacts.

Le but de l'invention est d'améliorer encore l'organisation et la compacité d'un tel dispositif de commutation de puissance refroidi.

L'invention atteint son but grâce à un dispositif de commutation de puissance comportant des organes semi-conducteurs de commutation présentant deux jeux de connexions, lesdits organes semi-conducteurs étant accolés par leur base sur une plaque de refroidissement électriquement conductrice à laquelle est raccordé un premier jeu de connexions, tandis que le second jeu de connexions des organes semi-conducteurs est relié à un circuit de commande et à des connecteurs de puissance, caractérisé en ce que ladite plaque comporte des bossages sur lesquels sont fixés ou plaqués les organes semi-conducteurs par leur base et en ce que le second jeu de connexions est relié au circuit de commande au travers d'un circuit de routage disposé globalement parallèlement au voisinage de ladite plaque mais isolé d'elle et comportant des ouvertures correspondant aux bossages plats de la plaque sous-jacente, lesquels sont dans un plan voisin du circuit de routage, moyennant quoi la connexion des organes semi-conducteurs à la plaque et au circuit de routage peut se faire sensiblement dans le même plan. Ainsi, selon l'invention, on a dissocié la fonction de distribution électrique sur deux circuits parallèles, à savoir le circuit d'alimentation ou de drain, avantageusement réalisé dans la plaque métallique de refroidissement emboutie, qui distribue le positif ou le négatif de la batterie vers le premier jeu de connexions (drain, semelle, broche) des organes de commutation et le circuit de routage, avantageusement réalisé une plaque métallique découpée, qui distribue les sorties de puissance et les liaisons vers la commande. La plaque du circuit de drain continue d'assurer le refroidissement électrique et cette dissipation thermique peut se faire d'une manière optimisée puisque la plaque est réservée à l'implantation de la partie dissipante des composants. Cette plaque peut notamment être mise en contact presque totalement, et notamment à l'endroit des bossages, avec une paroi de plastique du boîtier favorisant les échanges thermiques. La fonction de routage, c'est-à-dire le cheminement des pistes du composant vers l'extérieur ou vers la commande est réalisé à un autre étage, plus éloigné de la paroi de plastique. La plaque découpée réalisant le circuit de routage permet également avantageusement de comprendre le développer des languettes des connecteurs.

On connaît par le document DE 195 18 522 un dispositif de commande pour automobile dans lequel les composants de puissance disposés sur une plaquette de circuit imprimé sont refroidis par une plaque de refroidissement parallèle à la plaquette et comportant des bossages venant au voisinage immédiat desdits composants. Cette plaque de refroidissement est utilisée comme rail de courant pour l'alimentation de composants électriques distincts tels que des bobines. La plaque de refroidissement ne sert pas à l'alimentation des composants de puissance dont elle est au contraire isolée électriquement.

Avantageusement, selon l'invention, les organes semi-conducteurs ont à leur base une semelle (par exemple une semelle de drain) directement brasée ou plaquée sur les bossages de la plaque de refroidissement. Cependant, d'autres modes de connexion de la base des organes aux bossages sont possibles, tels qu'un collage de la semelle et une connexion électrique réalisée par une broche. On peut aussi envisager la brasure localisée de la semelle au laser, ce qui résout les difficultés liées à un défaut de planéité. Il est aussi possible que les MOS ou SMART soient livrées en puces nues : au lieu de souder le drain, on soude la puce directement sur le circuit de drain, et au lieu de souder les broches du composants, on.réalise une connexion ("bonding") entre la puce et le circuit de routage. Autrement dit, dans ce mode de réalisation, le premier jeu de connexion est réduit à une soudure directe et le second jeu de connexion est établi lors du montage du circuit.

Avantageusement, ledit dispositif de commutation constitue un module enfermé dans un boîtier en matière plastique comprenant des reliefs correspondant aux bossages de la plaque de refroidissement. En effet, du fait que la plaque de refroidissement ne sert qu'à l'implantation des organes de commutation, laquelle se fait sur les bossages précités, il est possible et avantageux de donner une forme adjacente tridimensionnelle quasi-identique au fond du boîtier sur lequel est accolée la plaque de refroidissement de manière à favoriser les échanges thermiques, puisque le pouvoir rayonnant du plastique est supérieur à celui du cuivre nu.

Dans le même but, le fond de boîtier ou le boîtier lui-même peut comporter vers l'extérieur des nervures servant à accélérer les échanges thermiques et aussi à raidir le fond du boîtier.

Avantageusement, le circuit de routage et la plaque de refroidissement sont espacés et réunis par une couche entretoise de matière non conductrice, telle qu'une matière plastique, destinée à assurer un placement relatif précis des deux circuits, l'ensemble formant un circuit double-face. Cette couche entretoise peut être associée aux deux circuits par collage (résine ou autre matière) ou par sertissage à chaud ou par ultrasons au moyen de pions déformés assurant la liaison mécanique. Avantageusement toutefois, la couche entretoise est surmoulée sur le circuit de routage, ce qui permet d'assurer le maintien mécanique des pistes découpées sur le circuit par exemple.

De préférence, une couche de couverture est également prévue sur l'autre face du circuit de routage, ce qui permet de protéger et d'étanchéifier le circuit et aussi de profiter du pouvoir de rayonnement infrarouge de la couche de couverture pour évacuer des calories vers l'extérieur du module. Cette couche de couverture peut être réalisée par un simple vernis ou une résine d'enrobage. Toutefois, il est avantageux de la prévoir sous la forme d'une couche de matière plastique surmoulée sur le circuit de routage, ce qui permet d'équilibrer les éventuelles tendances au cintrage du circuit de routage lors d'un surmoulage unilatéral.

La fixation de la plaque de refroidissement au sandwich surmoulé constitué de l'entretoise, du circuit de routage et de la couche de couverture, peut se faire par des rivets obtenus par surmoulage dans des empreintes prévues dans le sandwich précité.

Avantageusement, la plaque de refroidissement comporte des ailettes latérales, par exemple disposées contre les côtés du boîtier et augmentant encore la dissipation thermique. Ces ailettes peuvent être réalisées par pliage en même temps que l'emboutissage pour former les bossages.

La plaque de circuit de commande peut être disposée perpendiculairement ou parallèlement à la plaque de refroidissement et au circuit de routage (comme dans le document FR 2 800 567 précité) au moyen de pattes transversales. Mais, plus avantageusement, le circuit comporte une plaque de commande latérale, sur un côté du circuit de routage ; il est alors facile de prévoir des broches de connexion disposées sur le côté du circuit de routage et destinées à s'enficher dans la plaque du circuit de commande.

Avantageusement, le boîtier renferme deux modules de circuits superposés, disposés en vis-à-vis, et reliés à la même plaque de circuit de commande.

Naturellement, outre les composants semi-conducteurs mentionnés, les modules de circuits peuvent comporter des types très divers de composants montés en surface (CMS) tels que des relais, des capacités, des diodes, des résistances, et notamment des composants de type traversants qui peuvent être soudés par tous moyens, tels que vague sélective, robot, laser ou manuellement.

D'autres avantages et caractéristiques apparaîtront à la lecture de la description de l'invention, ainsi que des dessins annexés sur lesquels :

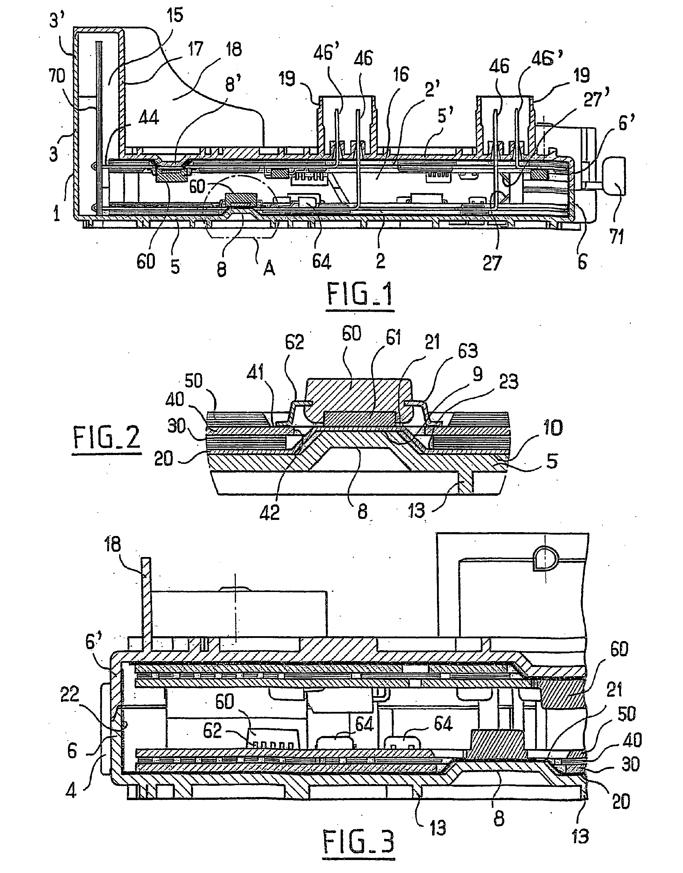

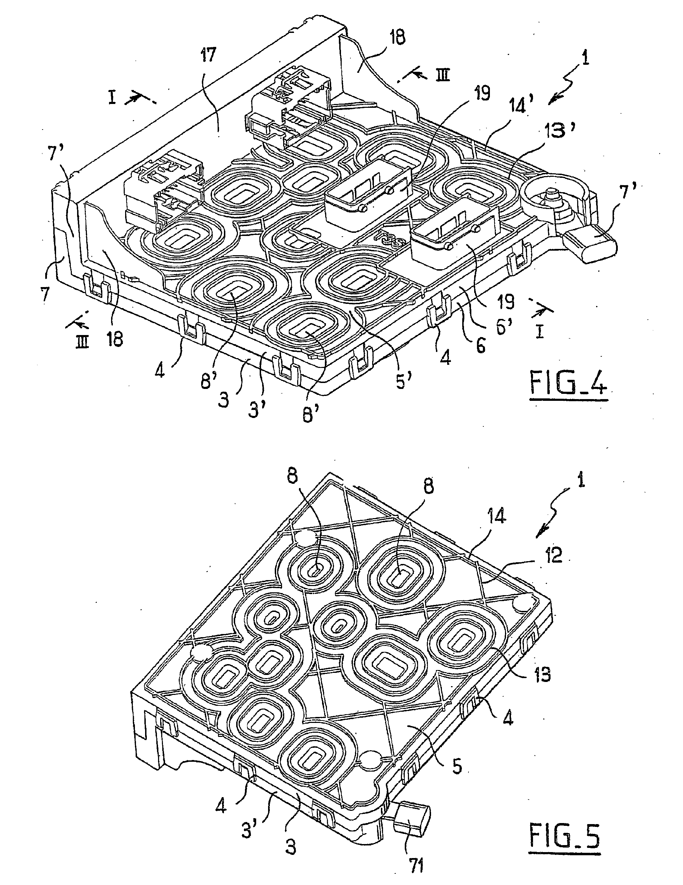

- la figure 1 est une vue en coupe transversale, selon le plan I-I de la figure 4, du dispositif de l'invention ;
- la figure 2 est une vue du détail A du dispositif de la figure 1;
- la figure 3 est une vue en coupe perpendiculaire à celle de la figure 1, selon le plan III-III de la figure 4, du dispositif de l'invention ;
- la figure 4 est une vue en perspective de dessus du dispositif de l'invention dans son boîtier ;
- la figure 5 est une vue en perspective de dessous du même dispositif ;
- la figure 6 est une vue en éclaté montrant les trois strates destinées à être empilées pour former un module conforme à l'invention ;
- la figure 7 est une vue en perspective d'un module conforme à l'invention.
- la figure 8 est une vue schématique en perspective avec coupe d'un circuit métallique surmoulé comportant des dégagements réservés pour le surmoulage des rivets de sertissage.
- La figure 9 est une vue schématique montrant sous un autre angle l'assemblage de la figure 8 après le surmoulage du rivet.

Le dispositif de l'invention tel que représenté renferme dans un boîtier plat 1 deux modules de commande respectivement inférieur et supérieur 2 et 2'.

Le boîtier 1 est constitué de deux demi-boîtiers plats inférieur et supérieur 3 et 3', formés d'un fond globalement plan 5, 5' sensiblement rectangulaire entouré d'un bord relevé bas 6, 6' sur trois côtés et d'un bord de nature différente 7, 7' sur le quatrième côté. Les demi-boîtiers sont assemblés entre eux par des attaches 4 sur les bords 6, 6' et éventuellement sur le bord 7, 7'.

Les fonds 5, 5' comprennent un certain nombre de bossages 8, 8' de même hauteur, tournés vers l'intérieur du boîtier 1. Ces bossages 8, 8' forment un plateau 9, sensiblement rectangulaire, surélevé par rapport au plan moyen 10 du fond 5, 5', et entouré d'une zone de raccordement en pente vers le plan 5, 5'. Le fond 5, 5' comprend un réseau de nervures 12, 13, 13', 14 disposées diagonalement (12) ou bien entourant les bossages (nervures 13, 13') ou bien périphériquement (nervures 14, 14'). Ces nervures contribuent au raidissement du fond mais surtout augmentent la surface d'échange thermique, notamment autour des bossages.

Le côté 7, 7' des demi-boîtiers 3, 3' est conformé de manière à ménager un volume secondaire 15, globalement orthogonal au volume principal 16 défini entre les fonds 5 et 5' en vis-à-vis. Ce volume secondaire 15, adjacent au volume principal 16 le long d'un côté du boîtier 1, est délimité en partie par une paroi 17 perpendiculaire au fond 13' et renforcée par deux équerres 18.

Les deux modules 2 et 2' sont formés de la même manière et on ne décrira en détail que le module 2. Il comprend essentiellement un circuit double-face formé d'un circuit de drain 20, d'une entretoise 30 et d'un circuit de routage 40 et, le cas échéant d'une couverture 50

Le circuit de drain 20 est réalisé par une plaque électriquement conductrice, métallique, par exemple en cuivre, sensiblement rectangulaire, comportant des bossages 21 sensiblement rectangulaires (ou d'une autre forme) correspondant aux bossages 8 du fond 5 de boîtier. La plaque 20 comporte sur deux côtés deux ailes latérales relevées 22, par exemple à angle droit ; chaque aile s'étend sur un peu moins de la moitié d'un côté et sa hauteur est presque celle du volume 16 entre les deux demi-boîtiers opposés ; cette disposition permet de prévoir des ailes semblables sur la plaque analogue du module supérieur 2'. Il va de soi qu'on pourrait prévoir un nombre d'ailettes différents, par exemple trois ailettes.

Les plateaux des bossages 21 définissent un plan, parallèle et décalé par rapport au plan du fond 23 de la plaque 20.

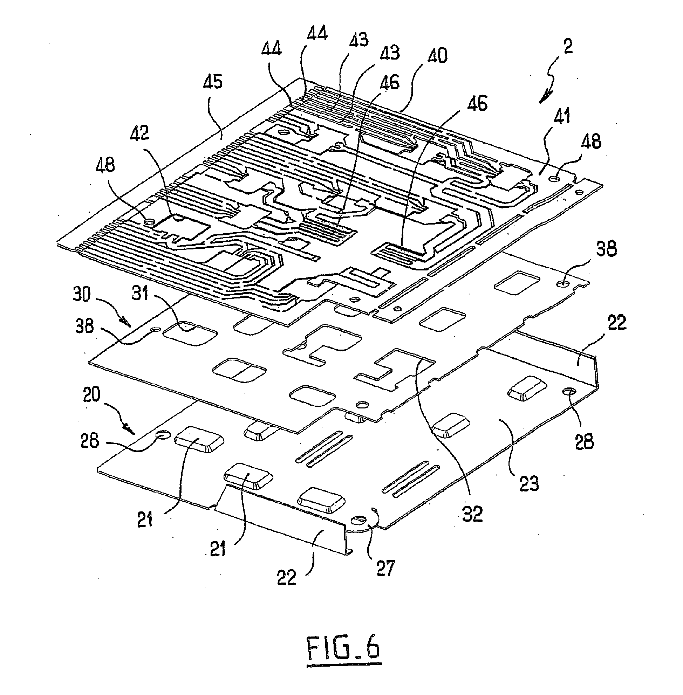

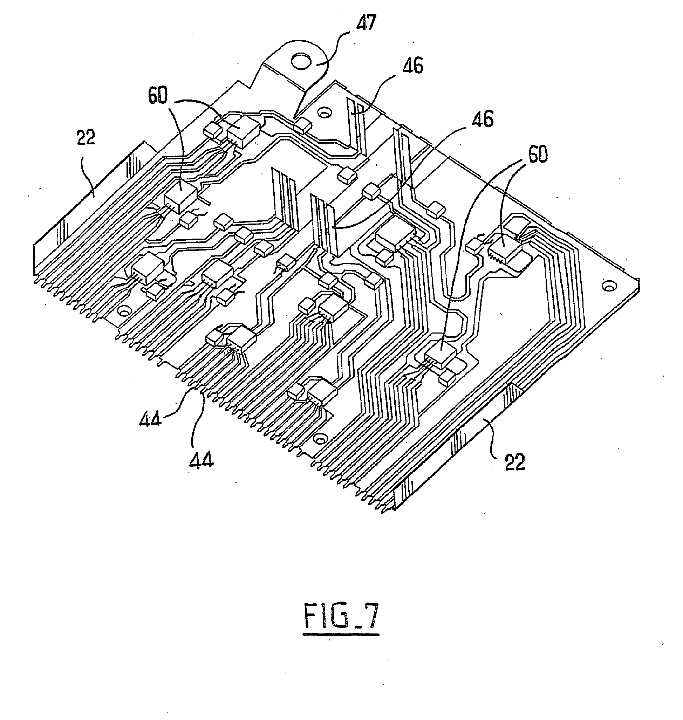

À ce plan correspond le plan de la surface supérieure 41 du circuit de routage 40 constitué par une plaque électriquement conductrice, métallique, par exemple en cuivre, découpée de manière à former d'une part des évidements sensiblement rectangulaires 42 correspondant aux bossages 21 de la plaque de drain 20 et destinés à laisser ceux-ci affleurer au même niveau que la surface 41, et d'autre part des pistes conductrices 43 conduisant à des broches 44 ramenées sur un côté de la plaque de circuit de routage. Sur la figure 6, ces broches sont représentées avant le déshuntage qui supprimera la partie de maintien 45. Le circuit de routage 40 comporte, en plus des broches 44 déjà mentionnées, d'autres broches 46, 46' montrées sur la figure 6 avant pliage et sur la figure 7 après pliage, permettant de sortir du boîtier perpendiculairement au plan des circuits, au niveau de deux connecteurs de puissance 19 situés sur le dessus du boîtier 1. Les broches 44 quant à elles sont enfichées dans une carte électronique de commande 70 disposée dans le volume secondaire 15.

Le circuit de routage 40 est maintenu parallèle et à la bonne distance du circuit de drain 20 grâce à une entretoise 30 réalisée en matière non conductrice. Cette entretoise comporte d'une part des évidements 31 correspondants aux bossages 21 du circuit de drain et aux évidements 42 du circuit de routage et d'autre part d'autres évidements 32 correspondant à des passages de broches, telles que les broches 46, 46'.

Des trous 28, 38, 48 se correspondant verticalement dans les trois plans 20, 30, 40 permettent le positionnement relatif lors de l'étape d'assemblage des trois plans et ensuite l'assemblage dans le boitier.

Le circuit de commande comporte des éléments semi-conducteurs 60 comportant, dans le cas d'un MOSFET par exemple, à leur base une semelle de drain 61 brasée sur le plateau d'un bossage 21 de la plaque de drain 20. L'élément 61 comporte aussi une ou plusieurs broches de grille 62 et une ou plusieurs broches de source 63, sous forme de pattes latérales, qui sont brasées sur une piste respective 43 de la surface 41 du circuit de routage, au bord d'un évidement 42.

Une couverture 50 de matière non conductrice de l'électricité est avantageusement formée au-dessus du circuit de routage, de préférence par surmoulage sur la plaque de routage, en même temps qu'on forme l'entretoise 30 également par surmoulage, ce qui a comme double avantage de protéger le circuit de routage des deux côtés mais aussi d'éviter le risque qu'il gauchisse en cas de surmoulage d'un seul côté. La couche de couverture 50 peut également être réalisée dans une résin d'enrobage.

Le circuit de commande comprend aussi d'autres éléments de circuits tels que les éléments 64, ne nécessitant pas de refroidissement intense, et disposés directement sur le circuit de routage 40.

Une cosse d'alimentation 71 destinée à être reliée à la batterie est connectée à une patte surélevée 27 formée dans un coin de la plaque de drain 40 de sorte que les deux pattes 27, 27' des deux plaques des modules en vis-à-vis puissent être reliées à la même cosse 71.

L'assemblage des différentes plaques peut se faire sans ou avec pions de sertissage.

Selon la première méthode, on découpe le cuivre pour former le circuit de routage 40, on procède au bossage et au pliage des oreilles du circuit de drain 20, on prépare une plaque entretoise 30 qu'on enduit sur ses deux faces d'une colle et on assemble les trois plaques ensemble. La colle est avantageusement une résine, par exemple de type époxyde, déposée en faible épaisseur (typiquement environ 200 µm, l'entretoise faisant elle-même par exemple 1 mm d'épaisseur). Dans cette méthode, l'entretoise assure le maintien mécanique de l'ensemble, avec la colle.

Selon la seconde méthode, l'entretoise assure ce maintien, en coopération avec des éléments d'assemblage transversaux, de type pions ou rivets. On découpe le cuivre pour former le circuit de routage 40, on surmoule le circuit de routage 40 pour former les deux couches de surmoulage 30, 50, puis on surmoule des pions de sertissage ; on procède au bossage et au pliage des oreilles du circuit de drain 20, on assemble le circuit de routage surmoulé 30, 40, 50 avec le circuit de drain bossé 20 et on vient sertir les pions de sertissage à chaud ou par ultrasons.

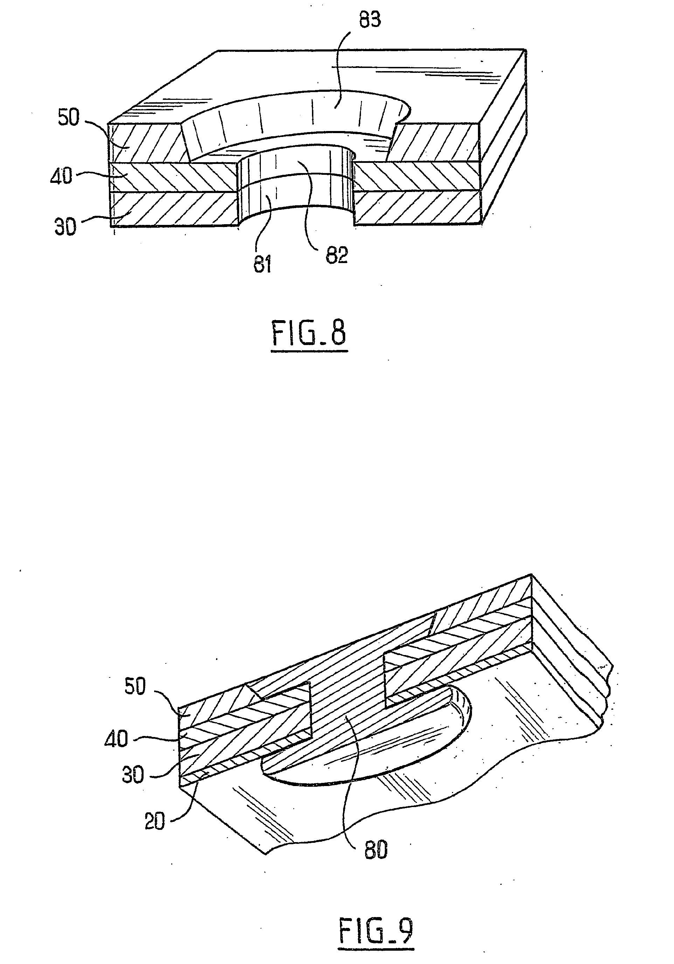

En alternative, au lieu de surmouler les pions de sertissage juste après le surmoulage de la plaque de routage 40 et de les déformer pour le sertissage après l'assemblage des plaques, on procède au surmoulage du circuit de routage 40, à la mise en forme du circuit de drain 20, à leur assemblage et on vient en étape finale directement former des rivets de sertissage 80 par surmoulage, comme illustré aux figures 8 et 9. Pour cela, on a au préalable réservé, lors du surmoulage des couches 30 et 50 sur la plaque de routage 40, des dégagements 81, 82, 83 permettant lors du second surmoulage de former directement le rivet 80, au moins en partie ; dans l'exemple représenté, les dégagements 81, 82 permettent la formation du corps du rivet 80, et le dégagement 83 permet la formation du pied du rivet 80. Le rivet 80 peut faire partie intégrante du boîtier surmoulé en même temps.

Dans les modes de réalisation représentés et décrits jusque là, on a illustré un module de puissance entièrement plat. Il pourrait fort bien être constitué de plusieurs sections planes faisant un angle entre elles, les circuits de drain, de routage et l'entretoise restant parallèles à l'intérieur de chaque section. Le module peut même se relier sur lui-même pour gagner en compacité.

## Revendications

1. Dispositif de commutation de puissance comportant des organes semi-conducteurs (60) présentant deux jeux de connexions, lesdits organes semi-conducteurs (60) étant fixés par leur base sur une plaque de refroidissement (20) électriquement conductrice à laquelle est raccordé le premier jeu de connexions (31), tandis que le second jeu de connexions (62, 63) des organes semi-conducteurs (60) est relié à un circuit de commande (70) et à des connecteurs de puissance (19), **caractérisé en ce que** ladite plaque (20) comporte des bossages (21) sur lesquels sont fixés ou plaqués les organes semi-conducteurs (60) par leur base et **en ce que** le second jeu de connexions (62, 63) est relié au circuit de commande et aux connecteurs de puissance au travers d'un circuit de routage (40) disposé globalement parallèlement au voisinage de ladite plaque (20) mais isolé d'elle et comportant des ouvertures (42) correspondant aux- bossages plats (21) de la plaque sous-jacente (20), lesquels sont dans un plan voisin du circuit de routage (40), moyennant quoi la connexion des dispositifs semi-conducteurs (60) à la plaque (20) et au circuit de routage (40) peut se faire sensiblement dans le même plan.

2. Dispositif selon la revendication 1, **caractérisé en ce que** les organes semi-conducteurs. (60) ont à leur base une semelle (61) brasée sur les bossages (21) de la plaque de refroidissement (20).

3. Dispositif selon l'une quelconque des revendications 1 ou 2, **caractérisé en ce que** une entretoise (30) non-conductrice isole le circuit de routage (40) et la plaque de refroidissement (20).

4. Dispositif selon la revendication 3, **caractérisé en ce que** l'entretoise (30) assure le maintien mécanique entre la plaque de refroisissement (20) et la circuit de routage (40).

5. Dispositif selon la revendication 3, **caractérisé en ce que** l'entretoise (30) est surmoulée sur le circuit de routage (40).

6. Dispositif selon l'une quelconque des revendications 1 à 5, **caractérisé en ce que** le circuit de routage (40) comporte à sa surface une couche de couverture (50).

7. Dispositif selon la revendication 6 **caractérisé en ce que** la couche de couverture (50) est surmoulée sur le circuit de routage (40).

8. Dispositif selon l'une quelconque des revendications 1 à 7, **caractérisé en ce que** la plaque de refroidissement (20) est accolée à une paroi (5) de boîtier (1) en plastique comportant des bossages (8) correspondant aux bossages (21) de la plaque.

9. Dispositif selon la revendication 8, **caractérisé en ce que** la paroi (5) de boîtier comporte des nervures extérieures (12, 13, 14).

10. Dispositif selon l'une quelconque des revendications 1 à 9, **caractérisé en ce que** la plaque de refroidissement (20) comporte des ailes pliées (22).

11. Dispositif selon l'une quelconque des revendications 1 à 10, **caractérisé en ce qu'**il comporte dans un même boîtier (1) deux ensembles superposés composés d'une plaque de refroidissement (20), d'une entretoise (30) et d'un circuit de routage (40).

## Claims

1. A power switching device comprising semiconductor members (60) having two sets of connections, said semiconductor members (60) being fixed by their base to an electrically conductive cooling plate (20) to which the first set of connections (31) is connected, while the second set of connections (62, 63) of the semiconductor members (60) is connected to a control circuit (70) and to power connectors (19), **characterized in that** said plate (20) has protuberances (21) onto which the semiconductor members (60) are fixed or pressed via their base and wherein the second set of connections (62, 63) is connected to the control circuit and to the power connectors through a routing circuit (40) that is placed generally parallel to and in the vicinity of said plate (20) but isolated therefrom and has openings (42) corresponding to the flat protuberances (21) of the subjacent plate (20), which protuberances lie in a plane close to the routing circuit (40), by means of which the semiconductor devices (60) may be fixed to the plate (20) and to the routing circuit (40) substantially in the same plane.

2. The device as claimed in claim 1, **characterized in that** the semiconductor members (60) have, at their base, a sole (61) soldered to the protuberances (21) of the cooling plate (20).

3. The device as claimed in either of claims 1 and 2, **characterized in that** a nonconductive spacer (30) isolates the routing circuit (40) from the cooling plate (20).

4. The device as claimed in claim 3, **characterized in that** the spacer (30) provides mechanical retention between the cooling plate (20) and the routing circuit (40).

5. The device as claimed in claim 3, **characterized in** thant the spacer is overmolded onto the routing circuit (40).

6. The device as claimed in any one of claims 1 to 5, **characterized in that** the routing circuit (40) includes, on its surface, a covering layer (50).

7. The device as claimed in claim 6, **characterized in that** the covering layer (50) is overmolded onto the routing circuit (40).

8. The device as claimed in any one of claims 1 to 7, **characterized in that** the cooling plate (20) is affixed to a wall (5) of a plastic housing (1) that has protuberances (8) corresponding to the protuberances (21) of the plate.

9. The device as claimed in claim 8, **characterized in that** the wall (5) of the housing includes external ribs (12, 13, 14).

10. The device as claimed in any one of claims 1 to 9, **characterized in that** the cooling plate (20) includes bent-up flanges (22).

11. The device as claimed in any one of claims 1 to 10, **characterized in that** it includes, in one and the same housing (1), two superposed sets composed of a cooling plate (20), a spacer (30) and a routing circuit (40).

## Patentansprüche

1. Leistungsschaltvorrichtung bzw. Leistungsumschaltvorrichtung bzw. Leistungsschalter, umfassend Halbleiterorgane bzw. -elemente (60), welche zwei Anschluß- bzw. Verbindungssätze aufweisen, wobei die Halbleiterelemente (60) durch ihre Basis an einer Kühlplatte (20) festgelegt sind, welche elektrisch leitfähig ist, mit welcher der erste Verbindungssatz (31) verbunden ist, während der zweite Verbindungssatz (62, 63) der Halbleiterelemente (60) mit einer Regel- bzw. Steuerschaltung (70) und Leistungsverbindern (19) verbunden ist, **dadurch gekennzeichnet, daß** die Platte (20) Erhebungen bzw. Vorsprünge (21) umfaßt, an bzw. auf welchen die Halbleiterelemente (60) über ihre Basis festgelegt oder plattiert sind, und daß der zweite Verbindungssatz (62, 63) mit der Steuer- bzw. Regelschaltung und den Leistungsverbindern über eine Bypass- bzw. Umleitungsschaltung (40) verbunden ist, welche im Allgemeinen parallel in der Nähe der Platte (20), jedoch isoliert von dieser angeordnet ist und Öffnungen (42) entsprechend den flachen bzw. ebenen Erhebungen (21) der darunter liegenden Platte (20) umfaßt, welche in einer Ebene benachbart der Umleitungsschaltung (40) liegen, mittels welcher die Verbindung der Halbleitervorrichtungen (60) mit der Platte (20) und der Umleitungsschaltung (40) im wesentlichen in derselben Ebene durchgeführt werden kann.

2. Vorrichtung nach Anspruch 1, **dadurch gekennzeichnet, daß** die Halbleiterelemente (60) an ihrer Basis eine Sohle bzw. einen Fuß (61) aufweisen, welche(r) an die Erhebungen (21) der Kühlplatte (20) gelötet ist.

3. Vorrichtung nach einem der Ansprüche 1 oder 2, **dadurch gekennzeichnet, daß** ein nicht-leitendes Zwischenstück bzw. ein nicht-leitender Abstandhalter (30) die Umleitungsschaltung (40) und die Kühlplatte (20) isoliert.

4. Vorrichtung nach Anspruch 3, **dadurch gekennzeichnet, daß** der Abstandhalter (30) die mechanische Halterung zwischen der Kühlplatte (20) und der Umleitungsschaltung (40) sicherstellt.

5. Vorrichtung nach Anspruch 3, **dadurch gekennzeichnet, daß** der Abstandhalter (30) über bzw. auf die Umleitungsschaltung (40) geformt bzw. gegossen ist.

6. Vorrichtung nach einem der Ansprüche 1 bis 5, **dadurch gekennzeichnet, daß** die Umleitungsschaltung (40) an ihrer Oberfläche eine Abdeckschicht (50) umfaßt.

7. Vorrichtung nach Anspruch 6, **dadurch gekennzeichnet, daß** die Abdeckschicht (50) über bzw. auf die Umleitungsschaltung (40) geformt bzw. gegossen ist.

8. Vorrichtung nach einem der Ansprüche 1 bis 7, **dadurch gekennzeichnet, daß** die Kühlplatte (20) an einer Wand (5) eines Gehäuses (1) aus Kunststoff festgelegt bzw. angeordnet ist, welches Erhebungen bzw. Vorsprünge (8) entsprechend den Erhebungen (21) der Platte umfaßt.

9. Vorrichtung nach Anspruch 8, **dadurch gekennzeichnet, daß** die Wand (5) des Gehäuses außenliegende Rippen bzw. Stege (12, 13, 14) umfaßt.

10. Vorrichtung nach einem der Ansprüche 1 bis 9, **dadurch gekennzeichnet, daß** die Kühlplatte (20) gebogene bzw. gefaltete Flügel (22) umfaßt.

11. Vorrichtung nach einem der Ansprüche 1 bis 10, **dadurch gekennzeichnet, daß** sie in einem gemeinsamen Gehäuse (1) zwei übereinander angeordnete Einheiten umfaßt, welche von einer Kühlplatte (20), einem Abstandhalter (30) und einer Umleitungsschaltung (40) zusammengesetzt bzw. gebildet sind.
